# EUROPÄISCHE PATENTSCHRIFT

(11) **EP 1 584 126 B1**
(45) Veröffentlichungstag und Bekanntmachung des Hinweises auf die Patenterteilung: **31.07.2013**
(21) Anmeldenummer: 03776845.4
(22) Anmeldetag: 10.11.2003
(51) Int. Cl.: H01R 9/26, H01R 13/514

(54) **MODULARES INSTALLATIONSGERÄT**
MODULAR INSTALLATION DEVICE
DISPOSITIF D'INSTALLATION MODULAIRE

(30) Priorität: 13.01.2003 DE 10301003
(43) Veröffentlichungstag der Anmeldung: 12.10.2005
(73) Patentinhaber: Siemens Aktiengesellschaft, 80333 München (DE)
(72) Erfinder: FREIMUTH, Michael, 92242 Hirschau (DE); ROYER, Fritz, 92256 Hahnbach (DE)
(86) Internationale Anmeldenummer: PCT/DE2003/003716
(87) Internationale Veröffentlichungsnummer: WO 2004/068645

(56) Entgegenhaltungen:
- DE-A- 19 650 988
- DE-C- 19 902 811
- US-A1- 2002 072 266

## Beschreibung

Die Erfindung betrifft ein modulares Installationsgerät.

Aus dem Produktkatalog der Firma Phoenix mit der Bezeichnung "Leiterplattenanschluss COMBICON 2002" ist, z.B. gemäß der Seiten 3 und 318, ein mit einem Gehäuse und einem Hutschienenhalter versehenes, modulares Einbaugerät bekannt, das abnehmbare Schraubklemmenblöcke aufweist, die mit einer blockeinheitlichen Kodierung zur lagerichtigen Zuführung der Blöcke, krallenähnlichen Fortsätzen zur Fixierung an dem Gehäuse und mit axial zu kontaktierenden Kontaktnadeln versehen sind. Ein derartiges Einbaugerät findet beispielsweise als Reiheneinbaugerät in einem Schaltschrank Verwendung und dient als Schalt- und/oder Schutzschaltgerät, Signalwandler oder dergleichen zur Umsetzung von Schalt- und/oder Steuerungskonzepten.

Die DE 196 50 998 A1 beschreibt eine elektrische Reihenklemme, an deren Stirnflächen zusätzlich Klemmen anzudocken sind, die dabei automatisch einen Andock-Stirnkontakt der Reihenklemme kontaktieren, der seinerseits über eine klemmeninterne Leitung mit der eingebauten oder aufgesteckten Elektronik elektrisch verbunden ist.

Die DE 199 02 811 C1 beschreibt eine Kodiervorrichtung und ein Kodierverfahren für ein elektrisches Gerät, wobei das elektrische Gerät ein erstes Bauteil mit einem ersten Kodierelementabschnitt und ein mit dem ersten Bauteil verbindbares zweites Bauteil mit einem zweiten Kodierelementabschnitt aufweist, der mit dem ersten Kodierelementabschnitt bei der Montage zu einem einzigen Kodierelement zusammensetzbar ist.

Der Erfindung liegt die Aufgabe zugrunde, ein mit Anschlussmodulen versehenes Installationsgerät anzugeben, das unter erschwerten Zugangsbedingungen ebenso wie die Anschlussmodule auf einfache Weise austauschbar ist, wobei die Anschlussmodule bei geringem Platzbedarf geräteseitig gegen unbeabsichtigtes Lösen sicherbar sowie verwechslungsfrei ankoppelbar und kontaktierbar sind.

Diese Aufgabe wird erfindungsgemäß durch die Merkmale des Patentanspruchs 1 gelöst; vorteilhafte Ausgestaltungen sind jeweils Gegenstand von weiteren Ansprüchen.

Durch das Haltemittel ist ein manuelles, d.h. handbetätigtes und somit werkzeugfreies Befestigen bzw. Lösen des erfindungsgemäßen Installationsgerätes an bzw. von einem Tragemittel auf einfache Weise möglich; die an vorgegebenen Modulplätzen des Installationsgerätes vorsehbaren Anschlussmodule sind über zugehörige Gegenkontaktmittel an den geräteseitig integrierten Kontaktmitteln und zwar quer zu deren Längsseite kontaktierbar, wobei die Anschlussmodule an den Modulplätzen mittels Kodiermittel und Gegenkodiermittel verwechslungsfrei und mittels Rastmittel und Gegenrastmittel sicherbar gegen unbeabsichtigtes Lösen anordbar sind, so dass sich durch die hieraus im Wesentlichen senkrecht zu den Kontaktmitteln bzw. vertikal zur Geräteoberseite ergebende An- und Absteckrichtung der Anschlussmodule ein An- bzw. Abkoppeln auch unter erschwerten Zugangsbedingungen, beispielsweise bei bereits verdrahteten Anschlussmodulen, mit einem geringen Platzbedarf auf einfache Weise erzielt werden kann. Bei einer Abkopplung wird von einem kurzen Abziehweg profitiert, durch den ein risikobehaftetes Nachziehen von angeschlossenen Leitern vermieden werden kann.

Mit Vorteil ist das Rastmittel des Installationsgerätes als elastischer und einen Widerhaken aufweisender Riegel sowie das Gegenrastmittel als eine den Widerhaken aufnehmende Raste ausgeführt, so dass insbesondere durch die gehäuseinnenseitig angeordneten Rast- und Gegenrastmittel ein Lösen des Riegels aus der Raste bzw. des entsprechenden Anschlussmoduls von dem Installationsgerät nur mittels eines Werkzeugs, also sicherheitsorientiert, möglich ist.

Vorteilhafterweise ist das Installationsgerät an den Modulplätzen mit jeweils einem Isolationsmittel versehen, welches an dem entsprechenden Kontaktmittel end- und/oder längsseitig angeordnet ist bzw. dieses abdeckt, so dass bei abgenommenem Anschlussmodul ein vorschriftengemäßer Berührungsschutz hinsichtlich der freiliegenden und ggf. spannungsführenden Kontaktmittel gewährleistet ist. Das jeweilige Isolationsmittel ist ferner als Isolationswinkel, insbesondere als in das Gehäuse integrierbares Steckelement, ausführbar, durch den das im Hinblick auf den Berührungsschutz abzudeckende Kontaktmittel auf einfache Weise sicherbar ist.

Die Erfindung sowie vorteilhafte Ausgestaltungen gemäß Merkmalen der weiteren Ansprüche werden im Folgenden anhand in der Zeichnung dargestellter Ausführungsbeispiele näher erläutert; darin zeigen:
- FIG 1: ein Installationsgerät mit angeordneten und weiteren anordbaren Anschlussmodulen in einer perspektivischen Darstellung; und
- FIG 2: ein Installationsgerät mit mehreren angeordneten Anschlussmodulen in einer perspektivischen Darstellung.

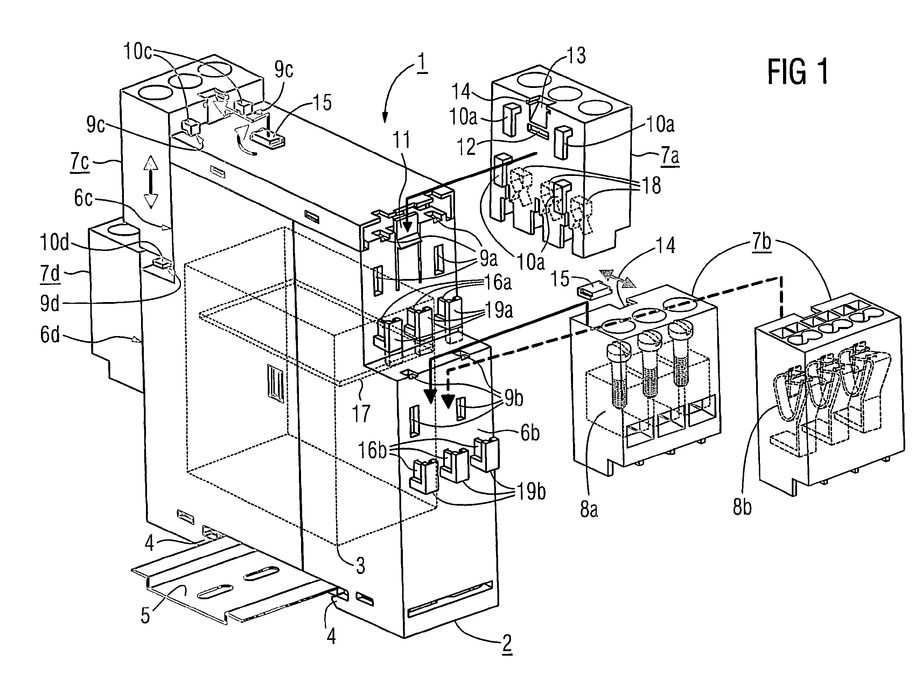

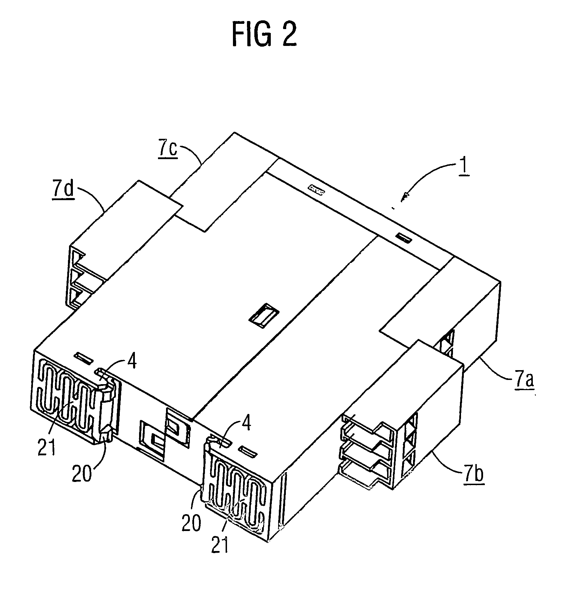

In FIG 1 ist ein modulares Installationsgerät 1 mit einem Gehäuse 2 gezeigt, das vorteilhafterweise eine schematisch dargestellte elektrische, elektromagnetische bzw. elektronische Geräteeinheit 3 aufweist. Mit der austauschbaren Geräteeinheit 3 ist der Verwendungszweck des Installationsgerätes 1 bestimmbar. Das Installationsgerät 1 weist ein in dem Gehäuse 2 integriertes Haltemittel 4 auf, das für ein daran ankoppelbares Tragemittel 5 vorgesehen ist. Das Tragemittel 5 ist beispielsweise in einem Verteiler, Schaltschrank oder dergleichen montiert, so dass das daran aufgeschnappte Installationsgerät 1 eine feste Einbaulage aufweist. Auf das Haltemittel 4 wird bei der Beschreibung der FIG 2 näher eingegangen.

Das Installationsgerät 1 bzw. das Gehäuse 2 ist ferner mit mehreren Modulplätzen 6a-6d versehen, wobei ein erster und ein zweiter Modulplatz 6a und 6b für ein daran anordbares erstes bzw. zweites Anschlussmodul 7a bzw. 7b an einer Stirnseite des Gehäuses 2 vorgesehen sind. Ein an einer anderen Stirnseite angeordneter dritter und vierter Modulplatz 6c und 6d sind jeweils mit einem zugehörigen dritten bzw. vierten Anschlussmodule 7c bzw. 7d bestückt. Somit erübrigt sich bei einem Defekt bzw. bei Wartungsarbeiten an einem verdrahteten Gerät ein kompletter Austausch desselben, bei dem auch ein Lösen aller Anschlussmittel respektive aller Leitungen erforderlich wäre.

Das Anschlussmodul 7b ist stellvertretend für die anderen Anschlussmodule 7b-7d vorteilhafterweise jeweils mit einem mehrpoligen Anschlussmittel versehen. Zwei Ausführungsvarianten des Anschlussmoduls 7b zeigen zum einen eine vereinfacht dargestellte Schraubklemme 8a und zum anderen eine vereinfacht dargestellte Federzugklemme 8b als Anschlussmittel. Selbstverständlich sind weitere Ausführungsvarianten, wie beispielsweise eine Schneidklemme oder dergleichen, einsetzbar. Die Anschlussmittel sind jeweils für eine daran anschließbare - hier nicht dargestellte - ein- oder mehradrige Leitung bestimmt.

An dem ersten und an dem zweiten Modulplatz 6a und 6b sind ein erstes bzw. ein zweites Kodiermittel 9a bzw. 9b an einer Gehäusewand vorgesehen. Die beiden Kodiermittel 9a und 9b korrespondieren jeweils mit einem zugehörigen ersten Gegenkodiermittel 10a bzw. mit einem - hier nicht dargestellten - zweiten Gegenkontaktmittel. Das erste Gegenkontaktmittel 10a wie auch das zweite Gegenkontaktmittel sind Teil eines ersten bzw. eines zweiten Anschlussmoduls 7a bzw. 7b. Sowohl die Kontaktmittel 9a,9b als auch das erste Gegenkontaktmittel 10a und das zweite Gegenkontaktmittel dienen zur modulplatzspezifischen, also verwechslungsfreien Zuordnung des ersten bzw. des zweiten Anschlussmoduls 7a bzw. 7b an dem Gehäuse 2.

Gleiches trifft auf den dritten und vierten Modulplatz 6c und 6d zu, die jeweils mit einem dritten bzw. mit einem vierten Kodiermittel 9c bzw. 9d versehen sind. Das dritte und vierte Kodiermittel 9c und 9d ist jeweils mit einem zugehörigen dritten bzw. vierten Gegenkodiermittel 10c bzw. 10d des anordbaren dritten bzw. vierten Anschlussmoduls 7c bzw. 7d kompatibel. Die Kodiermittel 9a-9d an den Modulplätzen 6a-6d des Gehäuses 2 bzw. die Gegenkodiermittel 10a-10d an den Anschlussmodulen 7a-7d sind also insgesamt auf einfache Weise gegeneinander kodiert. Dies trifft sowohl auf Anschlussmodule einer Anschlussseite als auch auf Anschlussmodule verschiedener Anschlussseiten zu, so dass ein Zuordnungsfehler und damit u.U. eine Gerätezerstörung vermieden werden kann.

Hierbei ist beispielhaft das erste Kodiermittel 9a des ersten Modulplatzes 6a durch vier von Gehäuseabschnitten gebildete Ausnehmungen in der Gehäusewand ausgeführt. Die Ausnehmungen oder auch Durchbrüche unterscheiden sich in ihren Lagen, Positionen und/oder Abmessungen von denen des zweiten Kodiermittels 9b zum Zwecke der Individualisierung. Das erste Gegenkodiermittel 10a ist in diesem Ausführungsbeispiel als Winkelelement ausgeführt und in Lage, Position und/oder Abmessung entsprechend den Ausnehmungen des ersten Kodiermittels 9a ausgeprägt, so dass eine Verwechslung, z.B. mit dem zweiten oder dritten Anschlussmodul 7b oder 7c ausgeschlossen ist.

Vorteilhafterweise dienen die Winkelelemente zugleich als Befestigungshaken der Anschlussmodule 7a-7d an dem Gehäuse 2 des Installationsgerätes 1. Gleiches trifft selbstverständlich auch für alle anderen Modulplätze 6b-6d und Anschlussmodule 7b-7d zu, wobei je Modulplatz 6b-6d eine individuelle Ausführung des jeweiligen Kodiermittels 9b-9d und des entsprechenden zweiten bzw. dritten und vierten Gegenkodiermittels 10c und 10d gegeben ist. Die Kodiermittel 9a-9d sind in einer weiteren Ausgestaltung auch an den jeweiligen Anschlussmodulen 7a-7d vorsehbar, wobei die Gegenkodiermittel 10a-10d an dem Gehäuse 2 in einer geeigneten Ausrichtung angeordnet sind.

Der erste Modulplatz 6a weist weiterhin stirnseitig ein Rastmittel 11 in der Gehäusewand des Gehäuses 2 auf. Der dritte Modulplatz 6c ist ebenfalls mit einem derartigen - hier nicht dargestellten - Rastmittel ausgestattet. An dem ersten Anschlussmodul 7a ist ein Gegenrastmittel 12 vorgesehen, das in Wechselwirkung mit dem Rastmittel 11 zur modulplatzspezifischen Ver- und Entriegelung des ersten Anschlussmoduls 7a im Sinne einer Verriegelungsmechanik dient. Ein unbeabsichtigtes Lösen des ersten Anschlussmoduls 7a ist somit ausgeschlossen. Selbst bei auftretenden Zugkräften, die über eine angeschlossene Leitung eingeleitet werden können, ist ein Lösen der Anschlussmodule ausgeschlossen. Dies ist insofern von Bedeutung, als dass ein Lösen unter Lastverhältnissen auf Grund einer daraus resultierenden Lichtbogenbildung zu einem Kontaktabbrand sowie zu einer Überhitzung und im ungünstigsten Fall zur Zerstörung des Gerätes führen kann. Gleiches trifft sinngemäß auf das dritte Anschlussmodul 7c zu, wobei nach dem Aufschieben der Anschlussmodule 7a-7d das Rastmittel 11 mit dem Gegenrastmittel 12 verrastet. Das Rastmittel 11 ist als elastischer und einen Widerhaken aufweisender Riegel ausgeführt. Der Riegel umfasst seinerseits ein- oder mehrteilige federnde Elemente.

Vorteilhafterweise ist das Rastmittel 11 Teil der Gehäusewand, wodurch eine einfache und im Hinblick auf den Fertigungsaufwand reduzierte Ausführungsvariante gegeben ist. Auch das Gegenrastmittel 12 ist auf einfache Weise, nämlich als eine den Widerhaken aufnehmende Raste ausgeführt. Der Riegel ist im Rahmen der Erfindung auch in einem der Anschlussmodule 7a-7d bzw. die Raste in dem Gehäuse 2 des Installationsgeräts 1 integrierbar. Die als Ausnehmung in einer Wandung des ersten Anschlussmoduls 7a ausgebildete Raste ist an einem Ende einer Rampe 13 angeordnet, über die beispielsweise mittels eines Schraubendrehers der Riegel gelöst werden kann.

An einem anderen Ende der Rampe 13 ist eine schlitzförmige Aufnahme 14 für ein darin einschiebbares Abschlusselement 15 vorgesehen. Das Abschlusselement 15 blockiert in eingeschobenem Zustand den Zugang zu dem Riegel und somit ein Entriegeln der Verriegelungsmechanik, so dass einer unerwünschten Demontage bzw. Abnahme des ersten Anschlussmoduls 7a vorgebeugt werden kann. Auf Grund der baulichen Überlappung des ersten Anschlussmoduls 7a gegenüber dem zweiten Anschlussmoduls 7b in an dem Installationsgerät 1 montiertem Zustand, erübrigt sich eine separate Verriegelungsmechanik für das zweite Anschlussmodul 7b, da dieses erst nach dem Lösen des ersten Anschlussmoduls 7a abgezogen werden kann.

An der einen Stirnseite, insbesondere an dem ersten Modulplatz 6a, des Gehäuses 2 ist ein erstes Kontaktmittel 16a angeordnet. An dem stufenartig abgesetzten zweiten Modulplatz 6b ist analog zu dem ersten Modulplatz 6a ein zweites Kontaktmittel 16b vorgesehen. Die an der Stirnseite herausragenden Kontaktmittel 16a,16b sind Teil eines - hier nicht gezeigten - s.g. Kontaktträgers. Der Kontaktträger ist auf einer Leiterplatte 17 der Geräteeinheit 3 platziert und befestigt. Der Kontaktträger dient u.a. als elektrisch leitende Verbindung zwischen den Kontaktmitteln 16a,16b und der Leiterplatte 17. Das zu dem ersten Kontaktmittel 16a zugehörige erste Anschlussmodul 7a ist mit einem vereinfacht dargestellten Gegenkontaktmittel 18 versehen, das innerhalb des ersten Anschlussmoduls 7a hinter einer Aussparung des zugehörigen Modulgehäuses angeordnet ist.

Das erste Kontaktmittel 16a bildet zusammen mit dem Gegenkontaktmittel 18 eine Anschlussschnittstelle zwischen dem Installationsgerät 1 und dem ersten Anschlussmodul 7a. Das erste Kontaktmittel 16a weist eine Längsseite auf, die zu einer Oberseite des Installationsgeräts 1 ausgerichtet ist. Beim Zuführen des ersten Anschlussmoduls 7a an den ersten Modulplatz 6a des Installationsgeräts 1 in Richtung des ersten Kontaktmittels 16a und entlang der einen Stirnseite, ist das erste Kontaktmittel 16a quer zu seiner Längsseite mit dem Gegenkontaktmittel 18 kontaktierbar, woraus sich eine senkrechte Kontaktierungsrichtung bzw. vertikale An- und Abkoppelrichtung ergibt. Im Gegensatz zu einem Einbaugerät mit einer horizontalen An- und Abkoppelrichtung hinsichtlich der Anschlussmodule, ist mit dem vorliegenden Installationsgerät 1 eine Demontage der Anschlussmodule 7a-7d auch bei einem geringen Zeilenabstand, beispielsweise im Schaltschrank, gewährleistet.

Vorteilhafterweise ist das erste Kontaktmittel 16a als eine Gruppe von flachen Kontaktelementen, insbesondere als Kontaktzungen oder als Kontaktfahnen, bzw. als Kontaktstifte ausgeführt. Die flachen Kontaktelemente sind mit ihrer flachen Seite parallel zu Seitenflächen des Gehäuses 2 angeordnet, wobei deren Anzahl frei wählbar ist. Zur Einhaltung der Kompatibilität ist das Gegenkontaktmittel 18 mit Vorteil als eine Gruppe von gabelförmigen Kontaktelementen ausgebildet, wodurch eine einfache und kontaktbegünstigende elektrisch leitende Kontaktverbindung gegeben ist. Das Gegenkontaktmittel 18 steht stellvertretend für alle anderen Gegenkontaktmittel der weiteren Anschlussmodule 7b-7d. Mittels der gabelförmigen Kontaktelemente - auch Federkontakte oder Tulpenkontakte genannt - ist hierbei eine lösbare Verbindung mit den flachen Kontaktelementen gegeben. Sinngemäß finden sich diese baulichen Ausgestaltungen auch an den weiteren Modulplätzen 6b-6d bzw. an den weiteren Anschlussmodulen 7b-7d wieder.

In den einzelnen Anschlussmodulen 7a-7d sind u.a. - hier nicht gezeigte - Stanz-Biegeteile integriert, die eine elektrisch leitende Verbindung einerseits zu dem jeweiligen Anschlussmittel und andererseits zu dem entsprechenden Gegenkontaktmittel gewährleisten. Selbstverständlich ist eine Ausführungsvariante des Installationsgeräts 1 mit gabelförmigen Kontaktelementen realisierbar, bei der die flachen Kontaktelemente Teil eines Anschlussmoduls sind.

An dem ersten und dem zweiten Kontaktmittel 16a und 16b sind beispielhaft end- und längsseitig ein erstes und ein zweites Isolationsmittel 19a und 19b im Sinne einer Berührungsschutzvorrichtung angeordneten. Das jeweilige als Gruppe von Isolationselementen ausgeführte Isolationsmittel 19a bzw. 19b deckt die zugehörigen Kontaktmittel 16a bzw. 16b ab, so dass vorteilhafterweise eine Berührung der ggf. spannungsführenden Kontaktmittel 16a bzw. 16b nach einem Abziehen der Anschlussmodule 7a bzw. 7b ausgeschlossen ist.

Die im vorliegenden Beispiel als Isolationswinkel bzw. als strichliert dargestellte Isolationsfortsätze ausgeführten Isolationsmittel 19a,19b gewährleisten die Einhaltung der Erfordernisse einschlägiger Normen, so z.B. der EN 61140 "Schutz gegen elektrischen Schlag". Die auch als Fingersicherheitsnasen bezeichneten Isolationsmittel 19a,19b können in einer vorteilhaften Weiterbildung auch als in das Gehäuse 2 integrierbare Steckelemente ausgeführt werden. Bei entsprechender Ausführung des Gehäuses 2 mit korrespondierenden Aufnahmen ist eine aufwandsarme Nachrüstung derartiger Isolationsmittel durchführbar. Selbstverständlich sind die Isolationsmittel 19a,19b in sinngemäßer Weise, insbesondere bei einer Ausführung mit flachen Kontaktelementen, auch an den Anschlussmodulen 7a-7d vorsehbar.

Durch die entsprechend der Kontaktierungsrichtung vorgegebenen Zuführungsrichtung der Anschlussmodule 7a-7d gemäß des mittels Zuführpfeilen dargestellten Montageablaufs, ergibt sich die Ausgestaltung der Kodier- und Gegenkodiermittel 9a-9d und 10a-10d, der Rast- und Gegenrastmittel 11 und 12 sowie der Isolationsmittel 19. Die Kodier- und Gegenkodiermittel 9a-9d und 10a-10d, das Rast- und Gegenrastmittel 11 und 12 sowie das Isolationsmittel 19 sind im Hinblick auf die beschriebenen vorteilhaften Ausführungsbeispiele ebenso durch gleichwirkende, jedoch zu den vorgenannten Mitteln unterschiedliche, Ausführungsvarianten realisierbar.

Die An- und Abkopplung des ersten Anschlussmoduls 7a an dem Installationsgerät 1 erfolgt - stellvertretend für die weiteren Anschlussmodule 7b-7d - im Wesentlichen senkrecht zu der Längsachse des ersten Kontaktmittels 16a. Durch die Ankopplung der jeweiligen Anschlussmodule 7a-7d an den Modulplätzen 6a-6d ist folglich eine Anordnung gegeben, die eine elektrische Kontaktierung und eine mechanische Verbindung inklusive Kodierung und Verriegelung im Sinne einer Wirkverbindung bedingt. Daraus ergibt sich selbst bei einer beengten Anordnung des Installationsgerätes 1, beispielsweise zwischen Verdrahtungskanälen in einem Schaltschrank, ein komfortabler Zugang.

Sofern eines oder mehrere der Anschlussmodule 7a-7d zu Reparatur- oder Nachrüstzwecken abgenommen werden sollen, erfolgt zuerst eine Entriegelung der Verriegelungsmechanik mittels eines Werkzeuges. Hierbei wird der Widerhaken des Riegels aus der Raste gedrückt und das entsprechende Anschlussmodul kann abgenommen werden. Bei Wiedermontage ist auf Grund der Kodier- und Gegenkodiermittel 9a-9d und 10-10d eine eindeutige Zuordnung aller gelösten Anschlussmodule zu dem entsprechenden Modulplatz sichergestellt.

In FIG 2 ist das Installationsgerät 1 in einer weiteren perspektivischen Darstellung gezeigt, bei dem jeweils zwei der Anschlussmodule 7a-7d in ihrer Montageendstellung an dem Gehäuse 2 parallel zu der einen bzw. zu der anderen Stirnfläche elektrisch und mechanisch verbunden sind. Das in dem Gehäuse 2 integrierte Haltemittel 4 weist zwei sich gegenüberliegende Rastelemente 20 auf, die als Teil des Haltemittels hinsichtlich des dazwischen vorsehbaren Tragemittels 5 auf Grund eines jeweils zugehörigen Federelements 21 beaufschlagt und dadurch selbstverklingend ausgeführt sind. Das jeweilige Rastelement 20 ist neben einer Anlaufschräge mit dem entsprechenden Federelement 21 einstückig ausgeführt, wobei das Federelement 21 seinerseits Teil des Gehäuses 2 ist. Daraus resultiert eine geringe Teilezahl und ein reduzierter Herstellungsaufwand.

Vorteilhafterweise lässt sich mit dem federbeaufschlagten Haltemittel 4 ein Lösen des auszutauschenden, ggf. defekten sowie schwer zugänglichen Installationsgerätes 1 von dem als Hutschiene ausgeführten Tragemittel 5 auf einfache Weise dadurch erzielen, dass eine Kraft - manuelles Ziehen oder Drücken - entgegen einer Federkraft einer der beiden Federelemente 21 eingeleitet wird, bis das entsprechende Rastelement 20 über den Rand der Hutschiene eingefedert ist. Über eine Schwenkbewegung, weg von der Hutschiene, kann dann das Installationsgerät 1 werkzeugfrei, d.h. handbetätigt gegen die Federkraft, im Sinne einer Demontage abgehoben werden.

Die zuvor erläuterte Erfindung kann wie folgt zusammengefasst werden:
Um ein mit Anschlussmodulen 7a-7d versehenes Installationsgerät 1 anzugeben, das unter erschwerten Zugangsbedingungen, ebenso wie die Anschlussmodule 7a-7d, auf einfache Weise bei geringem Platzbedarf austauschbar sein soll, ist vorgesehen, dass neben einem Haltemittel 4 für ein daran ankoppelbares Tragemittel 5 auch ein Modulplätze 6a-6d aufweisendes Gehäuse 2 für die Anschlussmodule 7a-7d gegeben ist. Hierbei ist einerseits ein Kodiermittel 9a-9d je Modulplatz 6a-6d und ein Gegenkodiermittel 10a-10d je Anschlussmodul 7a-7d zur modulplatzspezifischen Zuordnung sowie andererseits ein Rastmittel 11 an zumindest einem der Modulplätze 6a-6d und ein Gegenrastmittel 12 an zumindest einem der Anschlussmodule 7a-7d zur modulplatzspezifischen Ver- und Entriegelung angeordnet. Je Modulplatz 6a-6d ist ein eine Längsseite aufweisendes Kontaktmittel 16a,16b und je Anschlussmodul 7a-7d ist ein Gegenkontaktmittel 18 gegeben, wobei das Kontaktmittel 16a,16b quer zu seiner Längsseite mit dem Gegenkontaktmittel 18 kontaktierbar ist.

## Patentansprüche

1. Modulares Installationsgerät (1),
- mit einem Haltemittel (4) für ein daran ankoppelbares Tragemittel (5);
- mit einem, eine Mehrzahl Modulplätze (6a-6d) aufweisenden, Gehäuse (2);
- mit Anschlussmodulen (7a-7d), die jeweils an den Modulplätzen (6a-6d) anordbar und mit einem Anschlussmittel für eine daran anschließbare Leitung versehen sind;
**dadurch gekennzeichnet, dass**
- die Mehrzahl der Modulplätze vorgegeben ist; und das Installationsgerät
- mit einem Kodiermittel (9a-9d) je Modulplatz (6a-6d) und einem Gegenkodiermittel (10a-10d) je Anschlussmodul (7a-7d) zur modulplatzspezifischen Zuordnung;
- mit einem Rastmittel (11) an zumindest einem der Modulplätze (6a-6d) und einem Gegenrastmittel (12) an zumindest einem der Anschlussmodule (7a-7d) zur modulplatzspezifischen Ver- und Entriegelung; und
- mit einem eine Längsseite aufweisenden Kontaktmittel (16a,16b) je Modulplatz (6a-6d) und einem Gegenkontaktmittel (18) je Anschlussmodul (7a-7d), wobei das Kontaktmittel (16a,16b) quer zu seiner Längsseite mit dem Gegenkontaktmittel (18) kontaktierbar ist, versehen ist.

2. Modulares Installationsgerät nach Anspruch 1,
mit einer elektrischen, elektromagnetischen bzw. elektronischen Geräteeinheit (3).

3. Modulares Installationsgerät nach Anspruch 1,
mit zumindest einem federbeaufschlagten und selbstverklingenden Rastelement (20) als Teil des Haltemittels (4).

4. Modulares Installationsgerät nach Anspruch 1,
mit einer mehrpoligen Ausführung zumindest eines der Anschlussmodule (7a-7d).

5. Modulares Installationsgerät nach Anspruch 1,
mit einer Ausführung des jeweiligen Anschlussmittels als Schraub-, Federzug- oder Schneidklemme.

6. Modulares Installationsgerät nach Anspruch 1,
mit einer je Modulplatz (6a-6d) individuellen Ausführung des Kodiermittels (9a-9d) als von Gehäuseabschnitten gebildete Ausnehmung und einer Ausführung des Gegenkodiermittels (10a-10d) als Winkelelement.

7. Modulares Installationsgerät nach Anspruch 1,
mit einer Ausführung des Rastmittels (11) als elastischer und einen Widerhaken aufweisender Riegel sowie einer Ausführung des Gegenrastmittels (12) als eine den Widerhaken aufnehmende Raste.

8. Modulares Installationsgerät nach Anspruch 1,
mit einer Ausführung des Kontaktmittels (16a,16b) als Kontaktfahne bzw. Kontaktstift und einer Ausführung des Gegenkontaktmittels (18) als gabelförmiges Kontaktelement.

9. Modulares Installationsgerät nach Anspruch 1 und/oder 8,
mit einem an dem Kontaktmittel (16a,16b) end- und/oder längsseitig angeordneten, insbesondere das Kontaktmittel (16a,16b) abdeckenden, Isolationsmittel (19).

10. Modulares Installationsgerät nach Anspruch 9,
mit einer Ausführung des Isolationsmittels (19) als Isolationswinkel, insbesondere als in das Gehäuse (2) integrierbares Steckelement.

## Claims

1. Modular service device (1),
- having a retaining means (4) for a bearing means (5) which can be coupled thereto;
- having a housing (2) having a plurality of module locations (6a-6d);
- having connection modules (7a-7d) which can each be arranged at the module locations (6a-6d) and are each provided with a connection means for a line which can be connected thereto;
- **characterized in that**
- the plurality of module locations is predetermined; and the service device is provided with a coding means (9a-9d) per module location (6a-6d) and an opposing coding means (10a-10d) per connection module (7a-7d) for the purpose of providing module location-specific assignment;
- a latching means (11) at at least one of the module locations (6a-6d) and an opposing latching means (12) on at least one of the connection modules (7a-7d) for the purpose of providing module location-specific locking and unlocking; and
- a contact means (16a, 16b), having a longitudinal side, per module location (6a-6d) and an opposing contact means (18) per connection module (7a-7d), it being possible for the contact means (16a, 16b) to make contact with the opposing contact means (18) transversely with respect to its longitudinal side.

2. Modular service device as claimed in Claim 1,
having an electrical, electromagnetic or electronic device unit (3).

3. Modular service device as claimed in Claim 1,
having at least one spring-loaded and self-ringing latching element (20) as part of the retaining means (4).

4. Modular service device as claimed in Claim 1,
having a multi-pole design of at least one of the connection modules (7a-7d).

5. Modular service device as claimed in Claim 1,
in which the respective connection means is in the form of a screw terminal, a spring-loaded terminal or an insulation displacement contact.

6. Modular service device as claimed in Claim 1,
in which the coding means (9a-9d) is in the form, individually per module location (6a-6d), of a recess formed by housing sections, and the opposing coding means (10a-10d) is in the form of a bracket element.

7. Modular service device as claimed in Claim 1,
in which the latching means (11) is in the form of an elastic lock having a barb, and the opposing latching means (12) is in the form of a latch accommodating the barb.

8. Modular service device as claimed in Claim 1,
in which the contact means (16a, 16b) is in the form of a contact lug or contact pin, and the opposing contact means (18) is in the form of a fork-shaped contact element.

9. Modular service device as claimed in Claim 1 and/or 8,
having an insulating means (19) which is arranged on the end and/or longitudinal side on the contact means (16a, 16b) and, in particular, covers the contact means (16a, 16b).

10. Modular service device as claimed in Claim 9,
in which the insulating means (19) is in the form of an insulating bracket, in particular of a plug-in element which can be integrated in the housing (2).

## Revendications

1. Appareil d'installation modulaire (1),
- avec un moyen de fixation (4) pour un moyen de support (5) pouvant être accouplé à ce dernier ;
- avec un boîtier (2) présentant une pluralité d'emplacements de module (6a-6d) ;
- avec des modules de raccordement (7a-7d) qui peuvent être placés sur les emplacements de module (6a-6d) et qui sont pourvus chacun d'un moyen de raccordement pour une ligne pouvant être raccordée à ce dernier ;
**caractérisé en ce que**
- la pluralité d'emplacements de module est prédéfinie ; et le dispositif d'installation est pourvu
- d'un moyen de codage (9a-9d) par emplacement de module (6a-6d) et d'un moyen de contre-codage (10a-10d) par module de raccordement (7a-7d) pour une affectation spécifique aux emplacements de module ;
- d'un moyen d'encliquetage (11) sur au moins l'un des emplacements de module (6a-6d) et d'un moyen de contre-encliquetage (12) sur au moins l'un des modules de raccordement (7a-7d) pour un verrouillage et un déverrouillage spécifiques aux emplacements de module ; et
- d'un moyen de contact (16a, 16b) par emplacement de module (6a-6d) ayant un côté longitudinal et d'un moyen de contre-contact (18) par module de raccordement (7a-7d), le moyen de contact (16a, 16b) pouvant être mis en contact avec le moyen de contre-contact (18) transversalement à son côté longitudinal.

2. Appareil d'installation modulaire selon la revendication 1, avec une unité d'appareil (3) électrique, électromagnétique ou électronique.

3. Appareil d'installation modulaire selon la revendication 1, avec au moins un élément d'encliquetage (20) soumis à l'action d'un ressort et auto-effaçant faisant partie de l'élément de fixation (4).

4. Appareil d'installation modulaire selon la revendication 1, avec une configuration multipolaire d'au moins l'un des modules de raccordement (7a-7d).

5. Appareil d'installation modulaire selon la revendication 1, avec une configuration du moyen de raccordement respectif comme borne à vis, borne à ressort ou borne guillotine.

6. Appareil d'installation modulaire selon la revendication 1, avec une configuration individuelle du moyen de codage (9a-9d) par emplacement de module (6a-6d) comme cavité formée par des parties de boîtier et une configuration du moyen de contre-codage (10a-10d) comme équerre.

7. Appareil d'installation modulaire selon la revendication 1, avec une configuration du moyen d'encliquetage (11) comme verrou élastique à barbillon et une configuration du moyen de contre-encliquetage (12) comme encoche recevant le barbillon.

8. Appareil d'installation modulaire selon la revendication 1, avec une configuration du moyen de contact (16a, 16b) comme fiche de contact ou broche de contact et une configuration du moyen de contre-contact (18) comme élément de contact en fourche.

9. Appareil d'installation modulaire selon la revendication 1 et/ou la revendication 8,
avec un moyen d'isolement (19) placé sur le moyen de contact (16a, 16b) du côté de l'extrémité et/ou du côté longitudinal et recouvrant en particulier le moyen de contact (16a, 16b).

10. Appareil d'installation modulaire selon la revendication 9, avec une configuration du moyen d'isolement (19) comme équerre d'isolement, en particulier comme élément enfichable susceptible d'être intégré dans le boîtier (2).
